# EUROPEAN PATENT APPLICATION

(11) **EP 2 169 707 A1**
(43) Date of publication of application: **31.03.2010**
(21) Application number: 08777889.0
(22) Date of filing: 04.07.2008
(51) Int. Cl.: H01L 21/02, H01L 21/66

(54) **SINTERED SILICON WAFER**

(30) Priority: 13.07.2007 JP 2007184758
(71) Applicant: Nippon Mining & Metals Co., Ltd., Tokyo 105-0001 (JP)
(72) Inventor: SUZUKI, Ryo, Kitaibaraki-shi Ibaraki 319-1535 (JP); TAKAMURA, Hiroshi, Kitaibaraki-shi Ibaraki 319-1535 (JP)
(74) Representative: Hoarton, Lloyd Douglas Charles
(86) International application number: PCT/JP2008/062174
(87) International publication number: WO 2009/011235

(57) **Abstract**

Provided is a sintered silicon wafer, wherein the volume ratio of silicon oxide contained in the wafer is 0.01 % or more and 0.2% or less, the volume ratio of silicon carbide is 0.01% or more and 0.15% or less, and the volume ratio of metal silicide is 0.006% or less. Additionally provided is a sintered silicon wafer having a diameter of 400mm or more and having the following mechanical properties (1) to (3) measured by collecting a plurality of test samples from the sintered silicon wafers: (1) average value of the deflecting strength based on a three-point bending test is 20kgf/mm² or more and 50kgf/mm² or less; (2) average value of the tensile strength is 5kgf/mm² or more and 20kgf/mm² or less; and (3) average value of the Vickers hardness is Hv 800 or more and Hv 1200 or less. Even in the case of a large disk-shaped sintered silicon wafer, it is possible to provide a sintered compact wafer having definite strength and similar mechanical properties as single crystal silicon.

## Description

### TECHNICAL FIELD

The present invention relates to a sintered silicon wafer with superior mechanical properties.

### BACKGROUND ART

In the silicon semiconductor manufacturing process, a wafer prepared through single crystal pulling is primarily used. This single crystal silicon wafer has increased in size with the times, and it is anticipated that it will become 400mm or larger in the near future. In addition, a so-called mechanical wafer for testing is now required in order to establish the apparatus and peripheral technology necessary for the semiconductor manufacturing process.

Generally speaking, since this kind of mechanical wafer is subject to a fairly high precision testing, it needs to possess properties similar to the mechanical properties of single crystal silicon. Thus, even for testing use, the fact is that the single crystal silicon wafer actually used in the semiconductor manufacturing process has been conventionally used as is. However, since a single crystal silicon wafer that is 400mm or larger is extremely expensive, an inexpensive wafer having similar properties as single crystal silicon is in demand.

Meanwhile, as a component of such semiconductor manufacturing equipment, a proposal has also been made for application to a sputtering target formed from a rectangular or disk-shaped silicon plate. The sputtering method is being used as a means for forming thin films. There are several sputtering methods including the bipolar DC sputtering method, radio frequency sputtering method, magnetron sputtering method and the like, and thin films of various electronic parts are being formed using the sputtering characteristics unique to the respective methods.

This sputtering method is a method that faces a substrate as the anode and a target as the cathode, and generates an electrical field by applying a high voltage between the foregoing substrate and target under an inert gas atmosphere. Such the principles were used here that the ionized electrons and inert gas collide to form a plasma, the cations in the plasma collide with the target surface to knock out the target constituent atoms, and the discharged atoms adhere to the opposite substrate surface so as to form a film.

A sintered polycrystalline silicon compact is proposed for this kind of sputtering target, and this sintered compact target is demanded of considerable thickness, large size and a rectangular or disk shape in order to improve the deposition efficiency. Moreover, a proposal has also been made for using this sintered polycrystalline silicon compact as a board for retaining the single crystal silicon wafer. Nevertheless, polycrystalline silicon entails significant problems in that the sinterability is inferior, the obtained products have low density, and the mechanical strength is low.

In light of the above, in order to improve the properties of the foregoing sintered silicon compact, proposed is a sintered silicon compact formed by compression-molding and sintering the deoxidized silicon powder obtained by being heated under reduced pressure and within a temperature range that is 1200°C or higher and less than the melting point of silicon, wherein the crystal grain size of the sintered compact is set to be 100µm or less (for instance, refer to Patent Document 1).

However, the density of the sintered silicon compact will increase and the strength will also increase if the thickness of the sintered silicon compact manufactured as described above is thin (for instance, 5mm or less); but if the thickness becomes any thicker, the density will remain low (less than 99%) and the mechanical strength will therefore deteriorate. Thus, there is a problem in that it is not possible to manufacture a large rectangular or disk-shaped sintered silicon compact.

In light of the foregoing circumstances, the present applicant has previously proposed a sintered silicon compact in which the average crystal grain size is 50µm or less and the relative density is 99% or more, and its production method (refer to Patent Document 2). Although this sintered silicon compact possesses numerous advantages including high density and high mechanical strength, the further improvement of these properties is being demanded.
[Patent Document 1] Japanese Patent No. 3342898
[Patent Document 2] Japanese Patent No. 3819863

### DISCLOSURE OF THE INVENTION

The present invention was devised in view of the foregoing circumstances, and provided is a sintered compact wafer having definite strength and similar mechanical properties as single crystal silicon even in cases of a large sintered silicon wafer.

In order to achieve the foregoing object, the present inventors devised the sintering conditions, focused on the existence form of impurities, and discovered that it is possible to obtain a sintered silicon wafer with improved mechanical strength by adjusting the form and quantity of such impurities.

Based on the foregoing discovery, the present invention provides:
1. A sintered silicon wafer, wherein the volume ratio of silicon oxide contained in the wafer is 0.01% or more and 0.2% or less, the volume ratio of silicon carbide is 0.01% or more and 0.15% or less, and the volume ratio of metal silicide is 0.006% or less;
2. The sintered silicon wafer according to paragraph 1 above, wherein the average grain sizes of silicon oxide, silicon carbide and metal silicide are respectively 3µm or less; and
3. The sintered silicon wafer according to paragraph 1 or paragraph 2 above having a diameter of 400mm or more and having the following mechanical properties (1) to (3) measured by collecting a plurality of test samples from the sintered silicon wafers:
   (1) average value of the deflecting strength based on a three-point bending test is 20kgf/mm² or more and 50kgf/mm² or less;
   (2) average value of the tensile strength is 5kgf/mm² or more and 20kgf/mm² or less; and
   (3) average value of the Vickers hardness is Hv 800 or more and Hv 1200 or less.

Accordingly, it is possible to provide a sintered compact wafer having significantly improved strength even in cases of a large sintered silicon wafer, and provide a sintered silicon wafer having similar mechanical properties as single crystal silicon used as a mechanical wafer. In addition, since the strength is high, superior characteristics are yielded such as being easily processable into complex shapes without generating cracks and chipping, considerably improving the yield, and reducing manufacturing costs.

### BEST MODE FOR CARRYING OUT THE INVENTION

The present invention provides a sintered silicon wafer, wherein the volume ratio of silicon oxide contained in the wafer is 0,01% or more and 0.2% or less, the volume ratio of silicon carbide is 0.01% or more and 0.15% or less, and the volume ratio of metal silicide is 0.006% or less. Incidentally, as the metals that are included in the metal silicide, representative metals such as molybdenum, tungsten, chromium, manganese, titanium, iron and nickel may be considered; but the present invention is not limited to these metals and covers all metal silicides contained as impurities.

Consequently, even with sintered silicon wafers having a diameter of 400mm or greater, it is possible to make the average value of the deflecting strength (bending strength) of the wafer based on the three-point bending test to be 20kgf/mm² or more and 50kgf/mm² or less, the average value of the tensile strength to be 5kgf/mm² or more and 20kgf/mm² or less, and the average value of the Vickers hardness to be Hv 800 or more and Hv 1200 or less.

These are conditions that also coincide with the mechanical properties of a single crystal wafer. The greatest weakness of a sintered silicon wafer is the deterioration in the deflecting strength (bending strength), and the present invention is able to overcome this weakness.

When improving the foregoing mechanical properties, the quantity of silicon oxide, silicon carbide, and metal silicide is extremely important. With a sintered silicon wafer containing silicon oxide in excess of the volume ratio of 0.2%, silicon carbide in excess of the volume ratio of 0.15%, and metal silicide in excess of the volume ratio of 0.006%; it is not possible to achieve the mechanical properties that coincide with the mechanical properties of a single crystal wafer; namely, the average deflecting strength based on the three-point bending test of 20kgf/mm² to 50kgf/mm², the average tensile strength of 5kgf/mm² to 20kgf/mm², and the average Vickers hardness of Hv 800 to Hv 1200.

Although there will be no actual harm even if the volume ratio is less than 0.01% as the lower limit of the silicon oxide and even if the volume ratio of the silicon carbide is less than 0.01 %, these lower limits were provided because making the volume ratios to be less than the foregoing lower limits will increase the refining cost and is inefficient. The same applies to metal silicide, but a specific lower limit was not provided. In either case, it is desirable that the volume ratio of these components is low as possible.

Since this kind of sintered silicon compact wafer has high mechanical strength and superior workability, not only can it be used as a mechanical wafer (or dummy wafer), it can also be used as various components such as a sputtering target or a semiconductor manufacturing equipment holder.

Upon manufacturing components, the wafer has superior **characteristics in that** it is easily processable into complex shapes without generating cracks and chipping of the sintered silicon wafer and it allows for a considerable increase in the yield and a reduction of manufacturing costs.

Based on the above, the present invention provides a sintered silicon wafer having a diameter of 400mm or greater, wherein the average value of the deflecting strength of the wafer based on the three-point bending test is 20kgf/mm² or more and 50kgf/mm² or less, the average value of the tensile strength is 5kgf/mm² or more and 20kgf/mm² or less, and the average value of the Vickers hardness is Hv 800 or more and Hv 1200 or less. Conventionally, a sintered silicon wafer having a diameter of 400mm or greater and comprising the foregoing properties did not exist.

In addition, as a preferable condition of the present invention, the average grain sizes of silicon oxide, silicon carbide and metal silicide are made to be respectively 3µm or less. If the foregoing substances as impurities are fine, the influence of impurities will be less, and the properties of the sintered silicon wafer can be improved. The foregoing silicon oxide, silicon carbide and metal silicide tend to become concentrated at the crystal grain boundary under normal circumstances.

As a method of producing a sintered silicon compact, for instance, silicon powder prepared by pulverizing coarse grains of high-purity silicon of 5N or higher in a jet mill is deoxidized by being baked under reduced pressure within a temperature range of 1100 to 1300°C, preferably less than 1200°C, subject to primary sintering by a hot press, and then subject to HIP treatment within a temperature range of 1200 to 1420°C and at a pressure of 1000 atmospheres or greater.

Here, by using high-purity silicon powder and adopting the foregoing deoxidation conditions (temperature, time, atmosphere) based on the pulverization and baking of the powder, the HIP treatment temperature and the pressurized condition, the foregoing impurities content can be adjusted, and the sintering conditions are adjusted so that the volume ratio of silicon oxide contained in the wafer becomes 0.01% or more and 0.2% or less, the volume ratio of silicon carbide becomes 0.01% or more and 0.15% or less, and the volume ratio of metal silicide becomes 0.006% or less.

In addition, deoxidation is important, and sufficient deoxidation is required for obtaining a sintered silicon compact of fine crystals. The reason the baking temperature was set to be within a temperature range of 1000 to 1300°C, preferably less than 1200°C, is because the elimination of oxygen will be insufficient if the temperature is less than 1000°C. The existence of oxygen will become a factor that will directly assist the formation of silicon oxide.

Deoxidation will proceed at 1200°C or higher, but necking (phenomenon where powers adhere to each other) will increase, and, even if the necking is undone during the hot press, there are drawbacks in that there will be variations in the grain size distribution and the working hours will become long. Thus, it is desirable that the upper limit of the temperature is set to 1300°C.

In the HIP conditions, if the temperature is less than 1200°C and the pressure is less than 1000 atmospheres, similarly a high-density sintered silicon compact cannot be obtained, and at a temperature of 1420°C it will exceed the melting point of Si. With respect to the retention time, desirably the baking time is roughly 5 hours and the HIP treatment is performed for roughly 3 hours. Prolonged HIP treatment is undesirable since the crystal grains will become coarse. With that said, however, these times may be changed as needed according to the processing conditions, and the present invention is not limited to the foregoing length of time.

### [Examples]

The present invention is now explained in detail with reference to the Examples. These Examples are merely for facilitating the understanding of this invention, and the present invention shall in no way be limited thereby. In other words, various modifications and other embodiments based on the technical spirit claimed in the claims shall be included in the present invention as a matter of course.

### (Example 1)

Silicon powder prepared by pulverizing silicon coarse grains having a purity of 6N with a jet mill was deoxidized by baking treatment under reduced pressure at a temperature of 1000°C for 5 hours.

Subsequently, hot press was performed by setting the temperature to 1200°C and the bearing to 200kgf/cm², and this was thereafter subject to HIP at a temperature of 1200°C and a welding pressure of 1400 atmospheres to obtain a sintered silicon compact having a diameter of 400mm.

The quantity of silicon oxide, silicon carbide and metal silicide can be achieved based on the selection of the raw material; that is, the use of high-purity silicon, selection of the baking (deoxidation) conditions, and strict management of the HIP conditions. The obtained sintered silicon compact was ground into a silicon wafer.

With the sintered silicon compact wafer of Example 1, the volume ratio of silicon oxide was 0.16%, the volume ratio of silicon carbide was 0.12%, and the volume ratio of metal silicide was 0% (it did not reach the analyzable level). The mechanical strength of the sintered silicon wafer was measured. The measured mechanical strength is the average value of the five points arbitrarily sampled from the wafer.

Consequently, the average bending strength of the five sampled points was 25kgf/mm², the tensile strength of the same average was 9kgf/mm², and the Vickers hardness of the same average was Hv 1020. These values satisfied the properties required as a mechanical wafer, Incidentally, the characteristic values were rounded to the whole number. The results are shown in Table 1. Incidentally, in Table 1, the indecomposable amounts of metal silicide are indicated with "-"; and the same applies hereinafter.

As described above, since the sintered silicon compact wafer possesses sufficient strength, cracks or chipping did not occur even when the diameter of the wafer was increased to 420mm, 440mm, 460mm, 480mm...

**[Table 1]**

| | Oxide | Carbide | Metal Silicide | Deflecting Strength | Tensile Strength | Vickers Hardness |
|---|---|---|---|---|---|---|
| | volume % | volume % | volume % | kgf/mm² | kgf/mm² | Hv |
| Example 1 | 0.16 | 0.12 | - | 25 | 9 | 1120 |
| Example 2 | 0.01 | 0.01 | - | 44 | 19 | 840 |
| Example 3 | 0.2 | 0.15 | - | 21 | 7 | 1160 |
| Example 4 | 0.2 | 0.01 | - | 23 | 12 | 1060 |
| Example 5 | 0.05 | 0.05 | - | 37 | 16 | 970 |
| Example 6 | 0.10 | 0.10 | 0.001 | 21 | 9 | 1090 |
| Example 7 | 0.12 | 0.15 | 0.006 | 20 | 6 | 1180 |

| | | | | | | |
|---|---|---|---|---|---|---|
| The deflecting strength represents the average bending strength at the five sampled points. | | | | | | |

### (Examples 2 to 7)

Silicon powder having a purity of 5N and 6N was, as with Example 1, deoxidized by baking the powder under reduced pressure and within a temperature range of 1100 to 1300°C, this was subsequently hot pressed within a temperature range of 1200 to 1420°C and a bearing of 200kgf/cm² or greater, and the silicon obtained thereby was further subject to HIP treatment within a temperature range of 1200 to 1420°C and a pressure of 1000 atmospheres or higher so as to produce a sintered silicon in which, as shown in Table 1, the volume ratio of silicon oxide is 0.01 to 0.2%, the volume ratio of silicon carbide is 0.01 to 0.15%, and the volume ratio of metal silicide is 0.006% or less. The results are similarly shown in Table 1.

As shown in Table 1, in all Examples, the average value of the deflecting strength based on the three-point bending test was 20kgf/mm² or more and 50kgf/mm² or less, the average value of the tensile strength was 5kgf/mm² or more and 20kgf/mm² or less, and the average value of the Vickers hardness was Hv 800 or more and Hv 1200 or less. These possessed the mechanical properties of the present invention and could be used as a mechanical wafer.

### (Examples 8 to 10)

Next, based on Example 1 as a representative example of the present invention, the mechanical properties in cases of changing the respective average grain sizes of silicon oxide, silicon carbide and metal silicide were checked.

The results are shown in Table 2. According to Table 2, it proves that cases where the respective average grain sizes of silicon oxide, silicon carbide and metal silicide are 3µm or less are desirable in order to improve the mechanical properties of the silicon wafer.

Nevertheless, it should be understood that the scope of the respective average grain sizes of silicon oxide, silicon carbide and metal silicide will not cause any significant problem so as long as they are within the requirements of the present invention; specifically, the volume ratio of silicon oxide contained in the wafer of the present invention is 0.01% or more and 0.2% or less, the volume ratio of silicon carbide is 0.01% or more and 0.15% or less, and the volume ratio of metal silicide is 0.006% or less.

**[Table 2]**

| | Oxide | Carbide | Metal Silicide | Deflecting Strength | Tensile Strength | Vickers Hardness |
|---|---|---|---|---|---|---|
| | Average Grain Size | Average Grain Size | Average Grain Size | kgf/mm² | kgf/mm² | Hv |
| Example 8 | 0.12 | 0.12 | - | 31 | 11 | 1060 |
| Example 9 | 3 | 2 | - | 20 | 5 | 820 |
| Example 10 | 2 | 3 | - | 22 | 6 | 810 |

| | | | | | | |
|---|---|---|---|---|---|---|
| The deflecting strength represents the average bending strength at the five sampled points. (Unit of grain size: µ m) | | | | | | |

### (Comparative Example 1)

A sintered silicon wafer was prepared by using silicon having a purity of 5N, without performing baking (deoxidation) treatment, and respectively selecting the HIP temperature and welding pressure. With this sintered silicon wafer, the volume ratio of silicon oxide was 0.25%, the volume ratio of silicon carbide was 0.2%, and the volume ratio of metal silicide was -%. As with Example 1, the mechanical strength was measured. The results are shown in Table 3. The measured mechanical strength is an average value of the five sampled points.

As shown in Table 3, the bending strength was 15kgf/mm², the tensile strength was 10kgf/mm², and the Vickers hardness was Hv 1100. It did not satisfy the average value of the deflecting strength of 20kgf/mm² to 50kgf/mm² required as a mechanical wafer. This is considered to be because the volume ratio of silicon oxide contained in the wafer of the present invention did not satisfy the condition of 0.01% to 0.2% or less, and the volume ratio of silicon carbide did not satisfy the condition of 0.01 % to 0.15% or less.

**[Table 3]**

| | Oxide | Carbide | Metal Silicide | Deflecting Strength | Tensile Strength | Vickers Hardness |
|---|---|---|---|---|---|---|
| | volume % | volume % | volume % | kgf/mm² | kgf/mm² | Hv |
| Comparative Example 1 | 0.25 | 0.2 | - | 15 | 10 | 1100 |
| Comparative Example 2 | 0.22 | 0.17 | - | 18 | 6 | 1080 |
| Comparative Example 3 | 0.30 | 0.1 | - | 11 | 6 | 1140 |
| Comparative Example 4 | 0.20 | 0.18 | 0.06 | 10 | 4 | 1190 |
| Comparative Example 5 | 0.23 | 0.19 | 0.07 | 8 | 3 | 1200 |
| Comparative Example 6 | 0.35 | 0.20 | 0.08 | 7 | 3 | 1240 |
| Comparative Example 7 | 0.40 | 0.30 | 0.01 | 5 | 3 | 1310 |

| | | | | | | |
|---|---|---|---|---|---|---|
| The deflecting strength represents the average bending strength at the five sampled points. | | | | | | |

### (Comparative Examples 2 to 7)

Next, a sintered silicon wafer was prepared by using silicon having a purity ot 5N, without performing baking (deoxidation) treatment, and respectively selecting the HIP temperature and welding pressure. With this sintered silicon wafer, the volume ratio of silicon oxide was 0.20 to 0.40%, the volume ratio of silicon carbide was 0.1 to 0.30%, and the volume ratio of metal silicide was 0.08% or less. As with Example 1, the mechanical strength was measured. The results are shown in Table 3. The measured mechanical strength is an average value of the five sampled points.

As shown in Table 3, the deflecting strength was 5 to 18kgf/mm², the tensile strength was 3 to 10kgf/mm², and the Vickers hardness was Hv 1080 to Hv 1310. They did not satisfy the average value of the deflecting strength of 20kgf/mm² to 50kgf/mm² required as a mechanical wafer. In addition, there were some (Comparative Examples 4, 5, 6, 7) in which the average value of the tensile strength was less than a range of 5kgf/mm² to 20kgf/mm², and in this respect, there were also insufficient Comparative Examples. Moreover, there were some (Comparative Examples 5, 6, 7) in which the average value of the Vickers hardness exceeded Hv 1200, and in this respect also, they did not satisfy the conditions of the present invention.

This is considered to be because the volume ratio of silicon oxide contained in the wafer of the present invention did not satisfy the condition of 0.01% or more and 0.2% or less, the volume ratio of silicon carbide did not satisfy the condition of 0.01% or more and 0.15% or less, and the volume ratio of metal silicide did not satisfy the condition of 0.006% or less.

In particular, when the quantity of silicon oxide and silicon carbide increased and metal silicide additionally exceeded the range, this resulted in a significantly noncompliant sintered silicon wafer.

### INDUSTRIAL APPLICABILITY

The present invention is able to obtain a sintered compact wafer having significantly improved strength and similar mechanical properties as single crystal silicon even in cases of a large disk-shaped sintered silicon wafer, and this is effective as a mechanical wafer. In addition, since this sintered silicon compact wafer has high mechanical strength, it can also be used as a sputtering target or various components of semiconductor manufacturing equipment.

## Claims

1. A sintered silicon wafer, wherein the volume ratio of silicon oxide contained in the wafer is 0.01 % or more and 0.2% or less, the volume ratio of silicon carbide is 0.01% or more and 0.15% or less, and the volume ratio of metal silicide is 0.006% or less.

2. The sintered silicon wafer according to claim 1, wherein the average grain sizes of silicon oxide, silicon carbide and metal silicide are respectively 3µm or less.

3. The sintered silicon wafer according to claim 1 or claim 2 having a diameter of 400mm or more and having the following mechanical properties (1) to (3) measured by collecting a plurality of test samples from the sintered silicon wafers:
(1) average value of the deflecting strength based on a three-point bending test is 20kgf/mm² or more and 50kgf/mm² or less;
(2) average value of the tensile strength is 5kgf/mm² or more and 20kgf/mm² or less; and
(3) average value of the Vickers hardness is Hv 800 or more and Hv 1200 or less.
